**Europäisches Patentamt**

**European Patent Office**

**Office européen des brevets**

(19)

(11) Veröffentlichungsnummer: **0 046 215 B1**

(12) # EUROPÄISCHE PATENTSCHRIFT

(45) Veröffentlichungstag der Patentschrift:
20.11.86

(51) Int. Cl.⁴: **G 11 C 29/00**

(21) Anmeldenummer: **81105922.9**

(22) Anmeldetag: **27.07.81**

(54) Schaltungsanordnung für die Prüfung von Speicherzellen programmierbarer MOS-integrierter Halbleiterspeicher.

(30) Priorität: **14.08.80 DE 3030852**

(43) Veröffentlichungstag der Anmeldung:
**24.02.82 Patentblatt 82/8**

(45) Bekanntmachung des Hinweises auf die Patenterteilung:
**20.11.86 Patentblatt 86/47**

(84) Benannte Vertragsstaaten:
**DE FR GB**

(56) Entgegenhaltungen:
**WO - A - 81/00154**
**GB - A - 2 049 202**
**US - A - 4 103 189**
**US - A - 4 127 901**

(73) Patentinhaber: **Siemens Aktiengesellschaft Berlin und München, Wittelsbacherplatz 2, D-8000 München 2 (DE)**

(72) Erfinder: **Giebel, Burkhard, Dipl.-Ing., Asenweg 15, D-8000 München 83 (DE)**
Erfinder: **Moormann, Hans, Dr.rer.nat., Dipl.-Phys., Ludwig-Moser-Strasse 10, D-8013 Haar (DE)**
Erfinder: **Schrader, Lothar, Dr.rer.nat., Ulrich-von-Hutten-Strasse 44, D-8000 München 83 (DE)**

**Beschreibung**

Die vorliegende Erfindung betrifft eine Schaltungsanordnung für die Prüfung von Speicherzellen programmierbarer MOS-integrierter Halbleiterspeicher, insbesondere nichtflüchtiger Halbleiterspeicher vom Floating-Gate-Typ, mit einer aktiven Programmier- und Lesebetriebsart, in der alle Wortleitungen des Halbleiterspeichers bis auf eine ausgewählte Wortleitung auf einem tiefen Pegel liegen, und mit einer inaktiven Stromspar-Betriebsart (power down mode), in der alle Wortleitungen auf einem hohen Pegel liegen, wobei diese beiden Betriebsarten durch ein Signal repräsentiert sind, das für die aktive Betriebsart einen ersten Pegel und für die inaktive Betriebsart einen zweiten Pegel besitzt.

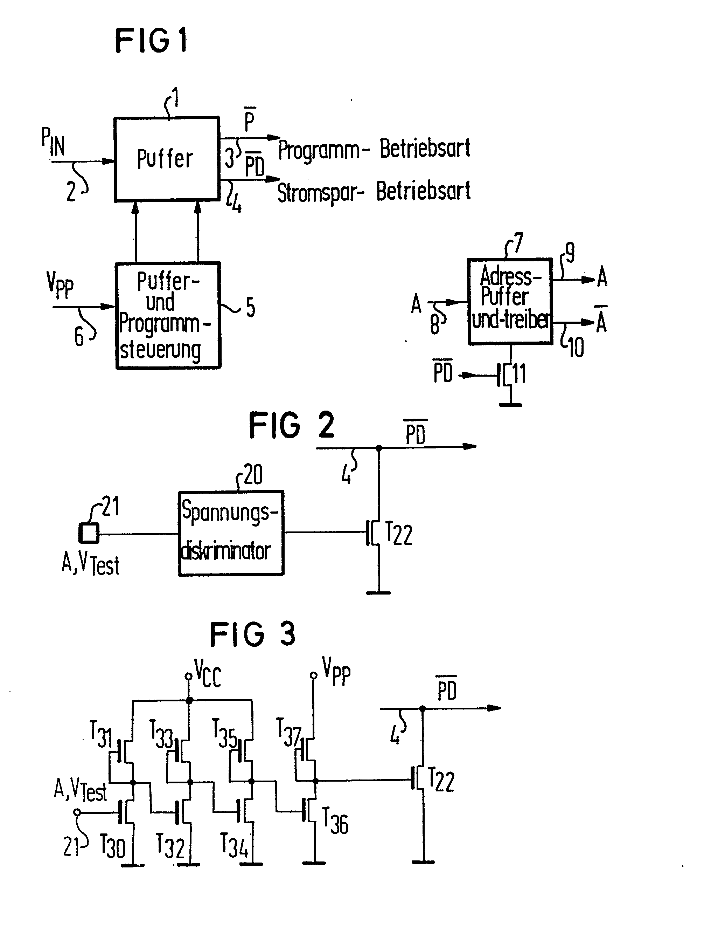

Halbleiterspeicher der vorstehend genannten Art sind beispielsweise aus der US-PS 4 094 012 bekannt. Zur generellen Erläuterung der beiden Betriebsarten eines derartigen Speichers, nämlich der aktiven Programmier- und Lese-Betriebsart sowie der inaktiven Stromspar-Betriebsart (power down mode) wird auf das schematische Blockschaltbild nach Fig. 1 Bezug genommen.

Für die inaktive Stromspar-Betriebsart wird über eine Eingangsleitung 2 ein Signal $P_{IN}$ in einen Puffer 1 eingegeben, welcher dann auf einer Ausgangsleitung 4 ein Signal $\overline{PD}$ zur Aktivierung der Stromspar-Betriebsart liefert.

Der Speicher enthält weiterhin mehrere Adresspuffer und -treiber, in die über äussere Anschlüsse des Speichers Adressen einspeisbar sind und welche komplementäre Steuersignale für Wortleitungsdecoder des Speichers erzeugen. Der Einfachheit halber sind in Fig. 1 diese Adresspuffer und -treiber in Form eines einzigen Blocks 7 dargestellt, wobei über eine Eingangsleitung 8 die generell mit A bezeichneten Adressen eingespeist werden und die genannten komplementären Steuersignale für die Wortleitungsdecoder als Signale A und $\overline{A}$ über Ausgangsleitungen 9 und 10 abgegeben werden. Diese Adresspuffer und -treiber sind über MOS-Schalttransistoren nach Masse gekoppelt, welche in Fig. 1 schematisch durch einen MOS-Schalttransistor 11 dargestellt sind. Diese Schalttransistoren werden durch das Signal $\overline{PD}$ angesteuert, wodurch die Adresspuffer und -treiber 7 in der Stromspar-Betriebsart unwirksam geschaltet werden können.

Für den Programmierbetrieb wird in eine Puffer- und Programmsteuerung 5 über eine Eingangsleitung 6 ein Programmierpotential $V_{PP}$ eingespeist, wobei diese Puffer- und Programmsteuerung 5 den Puffer 1 derart ansteuert, dass er (bei dann fehlendem Eingangssignal $P_{IN}$) ein die aktive Programmier- und Lese-Betriebsart kennzeichnendes Signal $\overline{P}$ an einer Ausgangsleitung 3 liefert. Das die Stromspar-Betriebsart kennzeichnende Signal $\overline{PD}$ auf der Ausgangsleitung 4 nimmt dann einen Pegel an, bei dem die Schalttransistoren 11 die Adresspuffer und -treiber 7 wirksam schalten.

Speicher der in Rede stehenden Art sind nun so ausgelegt, dass in der inaktiven Stromspar-Betriebsart alle Wortleitungen auf einem hohen Pegel liegen und in der aktiven Programmier- und Lese-Betriebsart alle Wortleitungen bis auf eine ausgewählte Wortleitung auf einem tiefen Pegel liegen.

Bei Halbleiterspeichern mit Speicherzellen vom Floating-Gate-Typ kann es auf Grund von Oxidfehlern beispielsweise zwischen dem Steuer-Gate und dem floatenden Gate, zwischen Source und floatendem Gate oder Drain und floatendem Gate zu Leckströmen kommen, welche zu einer ungewollten Umprogrammierung der Speicherzellen führen können. Aus diesem Grunde müssen die Speicherzellen des Halbleiterspeichers einem Test unterzogen werden, bei dem entweder an die Bitleitungen oder an die Wortleitungen eine hohe Spannung in der Grössenordnung der Programmierspannung angelegt wird. Ein derartiger Test kann sowohl bei gelöschtem als auch bei programmiertem Speicher durchgeführt werden, wobei in einem auf den Test folgenden Lesevorgang geprüft wird, ob in den Speicherzellen eine Umprogrammierung auf Grund des vorgenannten Leckstrommechanismus stattgefunden hat.

Wie oben ausgeführt, kann auf Grund der Auslegung des Speichers in der aktiven Programm- und Lese-Betriebsart jeweils nur immer eine Wortleitung zu einem Zeitpunkt auf das für die aktive Betriebsart notwendige hohe Potential gelegt werden. Daraus ergibt sich, dass die resultierende Testdauer somit gleich dem Produkt aus der notwendigen Testdauer pro Wortleitung und der Gesamtzahl der Wortleitungen in der Speichermatrix ist. Zum Beispiel ergibt sich für einen 16K-Bit-Speicher bei einer Testdauer von 6,4 Sek. pro Wortleitung eine Gesamttestzeit von über 13 Min.

Der vorliegenden Erfindung liegt die Aufgabe zugrunde, eine Möglichkeit zur Reduzierung der Testdauer anzugeben.

Diese Aufgabe wird bei einer Schaltungsanordnung der eingangs genannten Art erfindungsgemäss durch einen im Halbleiterspeicher vorgesehenen Kreis gelöst, über den das Betriebsart-Kennzeichnungssignal für die Speicherzellen-Prüfung, bei der die Wortleitungen mit einer der Programmierspannung entsprechenden Spannung beaufschlagt werden, als Funktion eines von aussen in den Halbleiterspeicher eingespeisten Signals ($V_{Test}$) von dem die aktive Betriebsart kennzeichnenden Pegel auf den die inaktive Betriebsart kennzeichnenden Pegel schaltbar ist, so dass alle Vortleitungen gleichzeitig auf einen für die Programmierung erforderlichen Pegel schaltbar sind.

Ausgestaltungen des Erfindungsgedankens sind in Unteransprüchen gekennzeichnet.

Die Erfindung wird im folgenden an Hand von in den Fig. 2 und 3 der Zeichnung dargestellten Ausführungsbeispielen näher erläutert:

An Hand des schematischen Blockschaltbildes nach Fig. 1 wurde bereits ausgeführt, dass im Programmierbetrieb das Programmierpotential $V_{PP}$ in die Puffer- und Programmsteuerung 5 eingespeist wird und dass dann der Puffer 1 über seine Ausgangsleitung 4 das Signal $\overline{PD}$ mit einem Pegel (hoher Pegel) liefert, bei dem die Adresspuffer und -treiber 7 zur Ansteuerung der Wortleitungs- decoder wirksam geschaltet werden. Normaler- weise ist dann jeweils nur immer eine nicht dargestellte Wortleitung des Speichers auswählbar und damit auf einen hohen Pegel schaltbar, während alle anderen Wortleitungen auf einem tiefen Pegel liegen.

Gemäss Fig. 2 ist im Halbleiterspeicher ein Kreis vorgesehen, über den das Signal $\overline{PD}$ trotz des aktiv geschalteten Programmierbetriebs auf den die Stromspar-Betriebsart kennzeichnenden Pegel (tiefer Pegel) bezogen werden kann. Zu diesem Zweck wird gemäss Fig. 2 über einen äusseren Anschluss 21 am Halbleiterspeicher ein Signal ($V_{Test}$) auf einen Spannungsdiskriminator 20 gegeben, welcher einen MOS-Schalttransistor $T_{22}$ ansteuert, über den die Ausgangsleitung 4 des Puffers 1, welche das Signal $\overline{PD}$ führt, nach Masse gekoppelt ist.

Der Anschluss 21 kann insbesondere gleich einem der äusseren Anschlüsse des Halbleiterspeichers sein, über den eine der Adressen A in den Speicher eingegeben wird. Dabei ist dann vorgesehen, dass die entsprechende Adresse A und das für den Testbetrieb in den Speicher eingegebene Signal ($V_{Test}$) unterschiedliche Spannungspegel besitzen, welche durch den Spannungsdiskriminator 30 unterschieden werden.

Wird über den Anschluss 21 eine Adresse eingegeben, so gibt der Spannungsdiskriminator 20 kein Signal ab, während er bei Eingabe des Signals ($V_{Test}$) für den Testbetrieb ein den Schalt- transistor $T_{22}$ durchsteuerndes Signal abgibt, so dass die Leitung 4 auf Masse gezogen und damit das Signal $\overline{PD}$ auf den Stromspar-Betiebsart kennzeichnenden Pegel geschaltet wird.

Fig. 3 zeigt eine Ausführungsform des Spannungsdiskriminators 20 nach Fig. 2 mit einer geraden Anzahl – hier 4 – von hintereinandergeschalteter Inverterstufen, welche jeweils durch einen gesteuerten Transistor $T_{30}$, $T_{32}$, $T_{34}$ beziehungs- weise $T_{36}$ sowie einen dazu in Reihe liegenden, als Last geschalteten MOS-Transistor $T_{32}$, $T_{33}$, $T_{35}$ beziehungsweise $T_{37}$ gebildet werden. Die ersten drei Stufen liegen dabei an einer Speicherversor- gungsspannung $V_{CC}$, während die letzte Stufe am Programmierpotential $V_{PP}$ liegt.

Durch Wahl der Anzahl der Inverterstufen und der Weiten-Längen-Verhältnisse (W/L-Verhältnis- se) und Einsatzspannungen der Einzeltransisto- ren kann erreich werden, dass ein derartiger Spannungsdiskriminator einen genau definierten Schwellwert besitzt, unterhalb von dem kein Ausgangssignal abgegeben wird, während oberhalb dieses Schwellwertes ein Ausgangssignal abgegeben wird, das in der an Hand von Fig. 2 be- schriebenen Weise der Transistor $T_{22}$ steuert.

**Patentansprüche**

1. Schaltungsanordnung für die Prüfung von Speicherzellen programmierbarer MOS-integrier- ter Halbleiterspeicher, insbesondere nichtflüchti- ger Halbleiterspeicher vom Floating-Gate-Typ, mit einer aktiven Programmier- und Lese-Betriebsart, in der alle Wortleitungen des Halbleiterspeichers bis auf eine ausgewählte Wortleitung auf einem tiefen Pegel liegen, und mit einer inaktiven Stromspar-Betriebsart (power down mode), in der alle Wortleitungen auf einem hohen Pegel liegen, wobei diese beiden Betriebsarten durch ein Signal repräsentiert sind, das für die aktive Betriebsart einen ersten Pegel und für die inaktive Betriebsart einen zweiten Pegel besitzt, gekennzeichnet durch einen im Halbleiterspeicher vorgesehenen Kreis (20, $T_{22}$; $T_{30}$ bis $T_{37}$ und $T_{22}$), über den das Betriebsart-Kennzeichnungssignal ($\overline{PD}$) für die Speicherzellen-Prüfung, bei der die Wortleitungen mit einer der Programmierspannung ($V_{PP}$) ent- sprechenden Spannung beaufschlagt werden, als Funktion eines von aussen in den Halbleiterspeicher eingespeisten Signals ($V_{Test}$) von dem die aktive Betriebsart kennzeichnenden Pegel auf den die inaktive Betriebsart kennzeichnenden Pegel schaltbar ist, so dass alle Wortleitungen gleichzeitig auf einen für die Programmierung erforderlichen Pegel schaltbar sind.

2. Schaltungsanordnung nach Anspruch 1, dadurch gekennzeichnet, dass zur Einspeisung des von aussen in den Halbleiterspeicher einspeisbaren Signals ($V_{Test}$) einer der äusseren Adressanschlüsse (21) des Halbleiterspeichers dient.

3. Schaltungsanordnung nach Anspruch 1 und/ oder 2, dadurch gekennzeichnet, dass der Kreis (20, $T_{22}$; $T_{30}$ bis $T_{37}$ und $T_{22}$) einen Spannungsdis- kriminator (20; $T_{30}$ bis $T_{37}$) und einen von diesem angesteuerten MOS-Schalttransistor ($T_{22}$) enthält, über den eine Leitung (4), über die das Betriebs- art-Kennzeichnungssignal ($\overline{PD}$) geliefert wird, nach Masse kurzschliessbar ist.

4. Schaltungsanordnung nach einem der Ansprüche 1 bis 3, dadurch gekennzeichnet, dass der Spannungsdiskriminator eine gerade Anzahl von hintereinandergeschalteten, durch MOS- Transistoren gebildete Inverterstufen ($T_{30}$, $T_{31}$ bis $T_{36}$, $T_{37}$), insbesondere vier Inverterstufen, um- fasst.

**Claims**

1. A circuit arrangement for testing storage cells in a programmable MOS-Integrated semiconductor store, in particular a non-volatile semiconductor store of the floating gate type having an active programming-and-read operating mode in which all except one selected one of the word lines of the semiconductor store are maintained at a low level, and an inactive power-down operating mode in which all the word lines are maintained at a high level, these two operating modes being determined by one control signal which is set at a first level for the active operating mode and at a second level for the inactive operating mode, characterised by a circuit (20, $T_{22}$; $T_{30}$–$T_{37}$ and $T_{22}$) contained in the semiconductor store for storage cell testing the word lines are acted upon by a voltage corresponding to the programming volt- age ($V_{PP}$) via the operating mode characterising signal ($\overline{PD}$) and are switched from the level characterising the active operating mode to the level characterising the inactive operating mode as a function of a signal ($V_{Test}$) fed into the semiconductor store from the exterior, so that all the word lines can be simultaneously connected to a level required for programming.

2. A circuit arrangement as claimed in Claim 1, characterised in that one of the outer address terminals (21) of the semiconductor store serves to feed the signal ($V_{Test}$) into the semiconductor store from the exterior.

3. A circuit arrangement as claimed in Claim 1 and/or 2, characterised in that the circuit (20, $T_{22}$; $T_{30}$–$T_{37}$ and $T_{22}$) contains a voltage discriminator (20; $T_{30}$–$T_{37}$) and a MOS-switching transistor ($T_{22}$) driven by the voltage discriminator, via which a line (4) supplying the operating mode characterising signal ($\overline{PD}$) can be short-circuited to earth.

4. A circuit arrangement as claimed in one of the Claims 1 to 3 characterised in that the voltage discriminator comprises an even number of series-connected inverter stages ($T_{30}$, $T_{31}$–$T_{36}$, $T_{37}$), formed by MOS-transistors, in particular four inverter stages.

## Revendications

1. Montage pour tester les cellules d'une mémoire intégrée MOS à semiconducteurs, programmable, notamment d'une mémoire à semiconducteurs non-volatile du type à grille flottante, comportant un mode actif de fonctionnement avec programmation et lecture, dans lequel toutes les lignes de transmission de mots de la mémoire à semiconducteurs sont situées, hormis une ligne sélectionnée de transmission de mots, à un niveau bas, et un mode inactif de fonctionnement à faible consommation de courant (power down mode), dans lequel toutes les lignes de transmission de mots sont situées à un niveau élevé, ces deux modes de fonctionnement étant représentés par un signal qui possède un premier niveau pour le mode actif de fonctionnement et un second niveau pour le mode inactif de fonctionnement, caractérisé par un circuit (20, $T_{22}$; $T_{30}$ à $T_{37}$ et $T_{22}$) prévu dans la mémoire à semiconducteurs et au moyen duquel le signal ($\overline{PD}$) peut être commuté, pour effectuer le test des cellules de mémoire, lors duquel les lignes de transmission de mots sont chargées par une tension correspondant à la tension de programmation ($V_{PP}$), depuis le niveau caractérisant le mode actif de fonctionnement au niveau caractéristant le mode inactif de fonctionnement en fonction d'un signal ($V_{test}$) introduit depuis l'extérieur dans la mémoire à semiconducteurs, de telle sorte que toutes les lignes de transmission de mots sont commutées simultanément à un niveau nécessaire pour la programmation.

2. Montage suivant la revendication 1, caractérisé par le fait que pour l'injection du signal ($V_{test}$) pouvant être injecté depuis l'extérieur dans la mémoire à semiconducteurs, on utilise l'une des bornes extérieures (21) de transmission d'adresses de la mémoire à semiconducteurs.

3. Montage suivant la revendication 1 et/ou 2, caractérisé par le fait que le circuit (20, $T_{22}$; $T_{30}$ à $T_{37}$ et $T_{22}$) contient un discriminateur de tension (20; $T_{30}$ à $T_{37}$) et un transistor de commutation MOS ($T_{22}$) commandé par ce discriminateur et au moyen duquel une ligne (4), au moyen de laquelle le signal ($\overline{PD}$) de caractérisation du mode de fonctionnement est délivré, peut être courtcircuitée à la masse.

4. Montage suivant l'une des revendications 1 à 3, caractérisé par le fait que le discriminateur de tension comporte un nombre pair d'étages inverseurs ($T_{30}$, $T_{31}$, $T_{36}$, $T_{37}$), notamment quatre inverseurs, branchés en série et constitués par des transistors MOS.

# FIG 1

P_IN → Puffer (1)

V_PP → Puffer- und Programm-steuerung (5)

$\overline{P}$ → Programm- Betriebsart

$\overline{PD}$ → Stromspar- Betriebsart

Adress-Puffer und-treiber (7)

A → A, $\overline{A}$

$\overline{PD}$

# FIG 2

A, V_Test (21) → Spannungs-diskriminator (20) → T22 → $\overline{PD}$

# FIG 3

V_CC, V_PP, $\overline{PD}$

T31 T33 T35 T37 T22

A, V_Test (21)

T30 T32 T34 T36